# EUROPEAN PATENT SPECIFICATION

(11) **EP 3 476 972 B1**
(45) Date of publication and mention of the grant of the patent: **03.09.2025**
(21) Application number: 17198365.3
(22) Date of filing: 25.10.2017
(51) Int. Cl.: B22F 10/32, B22F 10/77, B22F 12/00, B22F 12/70, B33Y 10/00, B33Y 50/02, H01L 21/67, C23C 16/44, H01J 37/32, B22F 10/28, B22F 12/90

(54) **PROCESS CHAMBER AND METHOD FOR PURGING THE SAME**
PROZESSKAMMER UND VERFAHREN ZUR SPÜLUNG DAVON
CHAMBRE DE TRAITEMENT ET SON PROCÉDÉ DE PURGE

(43) Date of publication of application: 01.05.2019
(73) Proprietor: L'Air Liquide, Société Anonyme pour l'Etude et l'Exploitation des Procédés Georges Claude, 75007 Paris (FR); Air Liquide Deutschland GmbH, 40476 Düsseldorf (DE)
(72) Inventor: Kaya, Cerkez, 47805 Krefeld (DE); Effinger, Markus, 47839 Krefeld (DE)
(74) Representative: Keenway Patentanwälte Neumann Heine Taruttis

(56) References cited:
- WO-A1-2018/077894
- CA-A1- 2 939 609
- DE-A1- 102015 213 011
- US-A- 5 728 425
- US-A1- 2010 272 891
- US-A1- 2013 186 857
- US-A1- 2014 154 416
- US-A1- 2016 052 079
- US-A1- 2017 014 905
- US-A1- 2017 275 753
- US-B1- 9 758 868

## Description

The present invention is directed to a process chamber and a method for purging the same.

Several processes are performed in an inert atmosphere to suppress undesired chemical reactions. This is the case, for example, in additive manufacturing. The process of additive manufacturing covers several applications. According to some applications, a product is manufactured by providing a precursor powder and by locally and selectively melting the powder, for example by a laser. If this is performed for several powder layers, a product can be obtained. It is desirable to perform the process in a defined atmosphere. The defined atmosphere may have a specific concentration of, for example, oxygen, nitrogen, argon and/or helium and/or may have a specific humidity.

For example, the presence of oxygen, in particular during the melting process step, may impair the quality of the product, in particular as the powder could oxidize. To reduce or avoid this effect, additive manufacturing is commonly performed in an inert atmosphere within a process chamber. For materials such as titanium based alloys also the presence of nitrogen can be disadvantageous.

Also, autoclaves are usually operated with an inert atmosphere. An autoclave is a process chamber that is sealed in an air-tight manner to its environment and that is used, in particular, for thermal and/or chemical treatment of products.

An inert atmosphere within a process chamber can be obtained by purging the process chamber with in inert gas. Therefore, usually the inert gas is introduced into the process chamber, thus displacing and replacing the gas initially contained within the process chamber. However, in particular due to adhesive effects binding oxygen on surfaces of the process chamber in particular small oxygen concentrations in the process chamber can only be reached by purging for rather long purging times. A particularly large amount of the inert gas might be needed for this purpose. For example, in additive manufacturing, purging usually takes up to 40 minutes, wherein a volume of the inert gas is consumed that is equal to - in theory - 2 or 3 times the volume of the process chamber. **In** practice, even much larger amounts of inert gas are often consumed. **In** particular, if the process chamber has to be opened frequently between processes and, thus, has to be purged often, a long purging time and a high gas consumption are disadvantageous.

From US 2013/186857 A1 a substrate processing system is known that comprises a chamber with a piston. However, purging this chamber requires more time and/or a higher consumption of purging gas than desired.

From US 2017/275753 A1 a chamber liner for a semiconductor process chamber is known.

It is, therefore, an object of the present invention to overcome at least in part the disadvantages known from prior art and, in particular, to provide a process chamber and a method for purging the same, wherein a purging time and/or a consumption of purging gas is particularly low.

A method for purging a process chamber is provided that comprises the features of claim 1.

The term process chamber is understood to cover any volume suitable for performing a process such as manufacture or treatment of a product placed within the process chamber. Preferably, the process chamber can be sealed in a gas-tight manner such that a predetermined atmosphere is adjustable within the process chamber. The predetermined atmosphere can comprise predetermined concentrations or partial pressures of one or more gases and/or a predetermined overall pressure. The predetermined atmosphere may comprise argon, helium, hydrogen, nitrogen, oxygen, carbon dioxide, carbon monoxide and/or ammonium, each with a respectively predetermined concentration or predetermined partial pressure. **In** particular, the predetermined atmosphere may be a mixture of argon and helium, a mixture of hydrogen and nitrogen, a mixture of argon and oxygen, a mixture of argon and nitrogen, a mixture of argon and hydrogen or a mixture of nitrogen and helium.

Also, the predetermined atmosphere may be a vacuum. **In** particular, the predetermined atmosphere may be an inert atmosphere, wherein the concentration of oxygen is below a predetermined value.

The process chamber is preferably formed within a housing, for example made with walls of a metal such as steel. The process chamber can have, for example, a cuboid, cubic or cylindrical shape. Preferably, the process chamber comprises at least one door or flap for opening the process chamber allowing to place a product or a precessor (like e. g. precursor powder or a pre-product that is to be treated) thereof into the process chamber and/or for removing the product or its precessor from the process chamber. Also, the process chamber can have an air lock for that purpose. Further, the process chamber preferably comprises at least one port for introducing a gas into the process chamber and/or for removing a gas from the process chamber. In particular via such a port, the predetermined atmosphere can be adjusted within the process chamber. Depending on the densities of the gases that are introduced into the process chamber and that are removed from the process chamber the respective port is preferably arranged at an upper side, a lower side or a lateral side of the process chamber. For example, a plurality of ports can be provided such that a specific process chamber can be used for different gases. Thereby, the port best suitable for introducing a specific gas into the process chamber and/or for removing a specific gas from the process chamber can be used.

With the described method purging can be performed in a particularly fast manner, whereby a particularly low amount of purging gas is consumed. This is obtained in particular by at least temporarily reducing the volume that is to be purged. Therefore, the purging section is provided. In particular, with the purging section a space is provided that can be purged easily as it is only a small volume. By extending the volume of the purging section, the entire process chamber can be purged. In contrast to conventional methods, therein the purging gas and the gas initially contained within the process chamber are not mixed or at least not mixed significantly.

Purging is supposed to be understood as an exchange of gas contained within the process chamber. For example, by purging air contained initially within the process chamber can be replaced with nitrogen. Subsequently, the process for which the process chamber is intended can be performed within the process chamber. This kind of purging can be considered a static process. The process for which the process chamber is intended is preferably started after the purging has been completed. However, it is also possible to start the process for which the process chamber is intended before the purging is completed.

After such a static purging it is also possible to provide a constant flow of the purging gas through the purging section. This could also be referred to as a continuous purging. A continuous purging can be performed under positive pressure and/or depending on a measured value.

With the described method, a static and/or a continuous purging can be performed. In particular, a static purging can be performed for initially exchanging gases within the process chamber and subsequently a continuous purging can be performed. The process for which the process chamber is intended can be performed in particular during the continuous purging. In particular step b) may be part of a static and/or continuous purging. Also, it is possible to vary a volume of the purging section during continuous purging and/or during performing the process for which the process chamber is intended. In particular, the volume of the purging section can be varied according to a stage of the process for which the process chamber is intended. This way, for example, the volume of a space in which selective laser melting is performed - which can be the purging section, for example - can be increased according to an increase of the volume of a manufactured product.

The purging section is a part of the process chamber. The purging section can be provided in such a way that a purging section, which does not exist before providing the purging section, is allocated or constituted. For example, a purging section can thus be provided in a process chamber with fixed boundaries by placing a plate into the process chamber such that one part of the process chamber - which becomes the purging section - is separated from the remaining part of the process chamber. In this case, the purging section only exists for performing the described method. After purging is completed, the purging section may be removed such that the entire process chamber forms a single section again. Alternatively, the purging section can be provided in such a way that the purging section is present permanently, whereas merely the volume of the purging section may vary over time as described herein. In such a case, the purging section may also have a negligible volume or even a volume of zero. For example, a process chamber may be divided into two sections by a plate, one of the sections being the purging section. By moving the plate, the volume of the purging section may be varied and can even become zero if the plate is brought in areal contact with a boundary of the process chamber.

The purging section is preferably a continuous part of the process chamber. That means that all parts of the purging section are connected to each other and that different parts of the purging section are not separated by other parts of the process chamber. However, it is alternatively preferred that the purging section comprises multiple subsections, which are not connected to each other and which are separated from each other by other parts of the process chamber. The purging section, whether it comprises a single continuous section or multiple separated subsections, is characterized in that the purging gas is introduced into the purging section.

The purging section is provided in step a) such that the volume of the purging section is smaller, preferably significantly smaller, than the total volume of the process chamber. It is particularly preferred that the purging section is provided with a negligible volume or even with a volume of zero.

In step b), the purging gas is introduced into the purging section. Preferably, the purging section is provided in step a) in such a way that none or only a small fraction of the gas originally contained within the process chamber is contained within the purging section. That way, when introduced into the purging section according to step b), the purging gas is not mixed or mixed only to as minor extent with the gas that is supposed to be displaced and replaced. Thus, the amount of purging gas required and/or the purging time can be reduced.

In a preferred embodiment of the method the purging gas is an inert gas.

With an inert purging gas an inert atmosphere can be obtained within the process chamber. The inert atmosphere can be characterized by an oxygen concentration being below a predetermined value. Concentrations of other gases thereby may remain unconsidered. Preferably, the inert gas is nitrogen, helium, argon, and/or carbon dioxide.

Alternatively, it is preferred that the purging gas is air.

In a further preferred embodiment of the method the purging is performed at least to such an extent that an oxygen concentration within the process chamber is below 1000 ppm [parts per million] after the purging.

The oxygen concentration allowable after purging can depend on the application. For example, for selective laser melting a concentration of maximally 1000 ppm can be acceptable. For other applications, however, lower oxygen concentrations are preferable. For example, for treating materials such as chromium and/or nickel an oxygen concentration of less than 20 ppm is preferable, for materials such as tantalum an oxygen concentration of less than 5 ppm is preferable. For treating plastic materials even oxygen concentrations of up to 5000 ppm may be acceptable.

According to the invention, the process chamber is divided into the purging section and a remaining section, wherein in step b) the volume of the purging section is increased, thereby reducing the volume of the remaining section and removing a gas contained in the remaining section from the process chamber.

The remaining section comprises all parts of the process chamber that are not part of the purging section. The total volume of the process chamber is thus the sum of the volume of the purging section and the remaining section. The total volume of the process chamber is preferably constant. The purging section and the remaining section are preferably configured such that the respective volumes of the sections can be varied. Therein, an increase in the volume of the purging section causes a decrease in the volume of the remaining section, and vice versa.

The remaining section can be a single continuous space or can comprise multiple parts that are separated from each other by parts of the purging section.

It is preferred that the purging section and the remaining section are separated from each other in such a way that the pressure is the same in both sections. **In** particular in this case introducing the purging gas into the purging section increases the volume of the purging section, whereby the volume of the remaining section is reduced. It is further preferred that the process chamber comprises at least one port that is arranged such that gas contained within the remaining section can exhaust from the process chamber. This port is preferably open during at least a part of step b). Thus, by decreasing the volume of the remaining section the pressure within the remaining section can remain unchanged.

With the volume of the purging section increasing by introduction of the purging gas, the gas initially contained within the remaining section is removed from the process chamber. This gas is supposed to be removed from the process chamber and to be replaced by the purging gas. In contrast to conventional methods for purging process chambers, here, the purging gas and the gas initially contained within the remaining section do not mix due to the separation between the purging section and the remaining section. Thus, the required amount of purging gas and/or the purging time can be reduced significantly.

In a further preferred embodiment of the method prior to step b) the volume of the purging section of the process chamber is less than 10 % of a total volume of the process chamber.

The total volume of the process chamber is defined as the volume that is to be purged. That is, any subspaces that are attached to the purging chamber or that form part thereof are included in the total volume of the process chamber only if gas from the (main) process chamber can access such subspaces. For example, the volume of a powder storage that is connected to the process chamber is included in the total volume of the process chamber only if the connection is configured such that gas from the process chamber can access the powder storage such that the powder storage has to be purged jointly with the process chamber.

Prior to step b) the volume of the purging section of the process chamber is preferably less than 5 % of the total volume of the process chamber. It is particularly preferred that prior to step b) the purging section has a negligible volume or even a volume of zero.

The smaller the purging section is compared to the total volume of the process chamber, the less gas initially contained within the process chamber is contained within the purging section prior to purging and, thus, the less mixing of this gas with the purging gas occurs which results in a lower purging gas consumption and/or in a shorter purging time.

The method further comprises the following step, which is performed after step b):
c) reducing the volume of the purging section, thereby increasing the volume of the remaining section, wherein the purging gas contained within the purging section is transferred to the remaining section.

The purging gas is introduced into the particularly small purging section according to step b). Thereby, the volume of the purging section is increased and the volume of the remaining section is decreased such that the gas initially contained within the remaining section is removed from the process chamber.

After step b), the volume of the purging section is preferably at least 70 %, preferably at least 90 % of the total volume of the process chamber, in particular at least 99 % of the total volume of the process chamber. It is even more preferred that after step b) the volume of the purging section is 100 % of the total volume of the process chamber. It is particularly preferred that the remaining section has the volume zero after step b). After step b), preferably all ports of the process chamber, in particular those via which the purging gas is introduced into the process chamber and/or those via which the gas initially contained within the remaining section can escape the process chamber, are closed.

The purging gas is transferred from the purging section to the remaining section. The purging gas can be transferred from the purging section to the remaining section for example, by opening at least one closable connection between the purging section and the remaining section. For example, a separating means between the purging section and the remaining section may comprise one or more valves that can be opened and closed, in particular driven electronically. Through such valves, the purging gas can be transferred from the purging section into the remaining section. It is also possible that the purging gas is transferred from the purging section into the remaining section through perforation openings within a separating means. In particular, the separating means can comprise a fabric or tissue through which the purging gas can penetrate. Such penetration can be possible at all times, that is in particular not merely upon an activation such as opening of a valve. In particular due to a particularly high difference in pressure at the different sides of the separating means, however, the penetration through the separating means may be intensified.

During step c) it is also possible to additionally introduce purging gas into the remaining section.

In a further preferred embodiment of the method, after purging the volume of the remaining section is at least70 %, preferably at least 90 % of the total volume of the process chamber.

After step b), the entire or almost the entire process chamber is preferably filled with the purging gas. In the present embodiment, the purging section is merely an auxiliary means. That is, the process for which the process chamber is intended, is not performed within the purging section, but within the remaining section. Therefore, step c) is performed. In step c), the purging gas contained within the process chamber preferably remains within the process chamber. Preferably, no gas is introduced into the process chamber or removed from the process chamber. Preferably, merely the purging gas contained within the purging section is transferred into the remaining section. The purging section is thereby preferably decreased significantly in volume or even eliminated entirely. It is also possible that the division of the process chamber into the purging section and the remaining section is eliminated. For example, a separating means between the purging section and the remaining section may be removed from the process chamber in or after step c) such that, subsequently, the process chamber has only one section. Here, this section can be regarded as the remaining section.

After step c), the entire or almost the entire process chamber is preferably filled with the purging gas and thus ready for being used to perform the process for which it is intended, that is, for example, for the treatment or manufacture of a product.

In a further preferred embodiment of the method in step a) the volume of the remaining section is increased, thereby reducing the volume of the purging section and removing a gas contained within the purging section from the process chamber.

In this embodiment, prior to step a), the purging section can be significantly larger than the remaining section. It is even possible that the remaining section has a negligible volume or a volume of zero or that the remaining section does not exist prior to step a). If initially there is no remaining section, the remaining section is preferably generated having a small volume. With the volume of the remaining section being increased, the volume of the purging section is decreased. This way, starting from an initially large purging section, a small purging section can be provided according to step a).

The volume of the remaining section can be increased, for example, by introducing air or nitrogen or any other auxiliary gas or liquid into the remaining section. Also, the purging gas can be used as the auxiliary gas. It is also possible to increase the remaining section mechanically in additionally or alternatively to introducing the auxiliary gas or liquid.

It is preferred that during introducing the auxiliary gas or liquid into the remaining section a port connected to the purging section is opened such that gas initially contained within the purging section can escape from the process chamber.

After the volume of the purging section has been decreased, the volume of the purging section is increased again in step b). Therein, however, the purging section is filled with purging gas. Thus, by decreasing and subsequently increasing the volume of the purging section, the gas initially contained within the purging section can be replaced by the purging gas. Thereby, the purging gas is not mixed with the gas within the remaining section. Thus, the effect described for the previous embodiment applies mutatis mutandis to the present embodiment. The purging time and/or the purging gas consumption are reduced since the gas contained within the process chamber can be exchanged with the gas initially contained within the process chamber and the purging gas being mixed.

According to the present embodiment, after step b), the entire or almost the entire process chamber is constituted by the purging section being filled with the purging gas. Here, in contrast to the previous embodiment, the purging section can be used to perform the process for which the process chamber is intended, that is, for example, for the treatment or manufacture of a product.

In one alternative of the invention, at least one movable separation element between the purging section and the remaining section is moved to increase or decrease the volume of the purging section of the process chamber, thereby decreasing or increasing the volume of the remaining section of the process chamber, respectively.

The at least one movable separation element is preferably rigid in such a way that a shape of the at least one movable separation element remains unchanged at least during purging. Thus, the volumes of the purging section and the remaining section can be varied only by moving the at least one separation element.

Preferably, the at least one separation element is provided within the process chamber such that the at least one separation element forms a gas-tight seal with boundaries of the process chamber such that the purging section and the remaining section are separated from each other in a gas-tight manner. Alternatively, it is also possible that the at least one separation element is provided within the process chamber such that gas can penetrate between the at least one separation element and the boundaries of the process chamber. It is, however, preferred that only a small amount of gas can penetrate between the at least one separation element and the boundaries of the process chamber.

The at least one movable separation element can be moved in particular during the process for which the process chamber is intended. For example, during selective laser melting the at least one movable separation element can be moved according to a progress of the manufacture of a product such that the process chamber is at all times just as large as necessary to accommodate the manufactured product. In particular, with every added layer of powder the at least one movable separation element can be moved to enlarge the space in which the product is manufactured can be enlarged as far as necessary due to the additional layer of powder.

It is particularly preferred that a plate is provided as the at least one separation element in such a way that the process chamber is divided horizontally by the separation element. Particularly in this case, the separation element is preferably configured such that it can be used as a substrate for a process that is supposed to be performed within the process chamber. For example, powder for additive manufacturing can be provided on top of such a separation element.

In a further preferred embodiment of the method the volume of the purging section is at least 90 % of the total volume of the process chamber after purging.

Thus, after step b), the entire or almost the entire process chamber is preferably filled with the purging gas. In the present embodiment, the remaining section is merely an auxiliary means. That is, the process for which the process chamber is intended, is not performed within the remaining section, but within the purging section.

As a further aspect a method for purging a process chamber is provided that comprises at least the following steps:
α) increasing a temperature of a gas initially contained in the process chamber at least to a first temperature,
β) introducing a purging gas, which is at a second temperature, into the process chamber, wherein the first temperature is higher than the second temperature.

The details and advantages disclosed for the previously described method for purging the process chamber can be applied to the present method, and vice versa. In particular, it is preferred also for the present method that the purging gas is an inert gas and/or that the purging is performed at least to such an extent that an oxygen concentration within the process chamber is below 1000 ppm [parts per million] after the purging.

Also with the present method purging can be performed in a particularly fast manner, whereby a particularly low amount of purging gas is consumed. This can be obtained in particular as the temperature of the gas initially contained within the process chamber is increased according to step α). The gas initially contained within the process chamber can be any gas or mixture of gaseous substances that constitutes the starting point for the described method. **In** particular, the gas initially contained in the process chamber can be air. This applies to most cases in practice, as purging of the process chamber is usually performed after the process chamber has been opened, for example, to place a product into the process chamber and/or for removing a product from the process chamber. However, the described method can be used for purging the process chamber irrespective of a composition of the gas initially present within the process chamber.

By increasing the temperature of the gas initially present within the process chamber, the density of this gas is decreased. Preferably, at least one port of the process chamber is opened during or after increasing the temperature according to step α) so that at least a part of the gas initially contained within the process chamber can escape the process chamber as the gas expands due to the increase in temperature. Thus, the total number of gas molecules or gas atoms contained within the process chamber is reduced. This leads to a first reduction of the number of oxygen molecules in the process chamber although the partial pressure of oxygen should not be significantly changed by this step.

As the gas initially contained within the process chamber is supposed to be displaced from the process chamber and replaced by the purging gas, the reduction of the density of the gas initially contained within the process chamber can reduce the purging time and/or the consumption of the purging gas. This is due to the fact that a lower number of gas molecules or gas atoms has to be removed from the process chamber after step α). Furthermore, the number of molecules adsorbed on surfaces in the process chamber is reduced due to the increased temperature.

The purging gas introduced into the process chamber according to step β) is colder than the gas initially contained within the process chamber. Thus, the purging gas is introduced into the process chamber at a relatively higher density as in a case where the purging gas has the same temperature as the gas initially contained within the process chamber.

The larger the difference between the first and second temperature is, the larger is the difference in densities of the gases and the more can the purging time and the purging gas consumption be reduced. The first temperature is preferably at least 20 K, in particular at least 50 K higher than the second temperature.

In a preferred embodiment of the method the purging gas is an inert gas.

With an inert purging gas an inert atmosphere can be obtained within the process chamber. The inert atmosphere can be characterized by an oxygen concentration being below a predetermined value. Concentrations of other gases thereby may remain unconsidered. Preferably, the inert gas is nitrogen, helium and/or argon.

In a further preferred embodiment of the method the purging is performed at least to such an extent that an oxygen concentration within the process chamber is below 5 ppm [parts per million] after the purging.

Preferably, the purging is performed at least to such an extent that an oxygen concentration within the process chamber is below 2.5 ppm [parts per million] after the purging. In particular with an oxygen concentration of less than 5 ppm, preferably of less than 2.5 ppm, an atmosphere can be considered inert.

In a further preferred embodiment of the method the second temperature is below 0 °C.

The purging time and/or the purging gas consumption can be reduced in particular if not only the temperature of the gas initially contained within the process chamber is increased according to step α), but if also the purging gas is introduced into the process chamber according to step β) at a particularly low temperature. Preferably, the second temperature is even lower than -20°C. In order to prevent damage from the process chamber and/or a product placed therein, the temperature of the process gas is at least above a minimum value. The second temperature is preferably above -30 °C.

In a further preferred embodiment of the method prior to step α) a temperature of the gas initially contained within the process chamber is at least 50 K lower than the first temperature.

Preferably, the temperature of the gas initially contained within the process chamber is at least 75 K lower than the first temperature. In this embodiment, the temperature of the gas initially contained within the process chamber is increased during step α), that is from beginning to end of step α), by at least 40 K, preferably by at least 100 K and in particular even by at least 200 K. This can contribute to a respective difference between the first and second temperatures.

In a further preferred embodiment the method further includes evaporating liquid nitrogen prior to step β) and using the evaporated nitrogen as the purging gas in step β).

Nitrogen and argon are inert gases that are particularly suitable for many different processes. Also, nitrogen and argon can be easily stored in their liquid states, for example in storage tanks. Prior to using the nitrogen and/or argon in the gaseous state, the nitrogen and/or argon extracted from the storage tank can be evaporated, for example within an evaporator or a heat exchanger for exchanging heat with environmental air or a medium such as water. In particular if evaporated nitrogen and/or argon is used, a particularly low second temperature can be achieved easily. Argon can be used in particular in the treatment of materials such as titanium.

Alternatively, other gases can be used, in particular such gases that can be liquified and stored in their liquid state. Also, mixtures of gases can be used.

In a further preferred embodiment of the method at least one of the following parameters
- a flow rate of the purging gas in step β) and
- a purging time, over which step β) is performed,
is controlled depending on at least one of the following parameters:
- a temperature measured within the process chamber and
- an oxygen concentration measured within the process chamber.

This embodiment is particularly suitable for obtaining an inert atmosphere within the process chamber.

The flow rate of the purging gas is the amount of the purging gas, in particular a mass or a volume of the purging gas, that is introduced into the process chamber per time. That is, the flow rate can be a mass flow rate or a volume flow rate. The purging time is the total time over which the purging is performed, that is in particular a total time from beginning to end of step β). The higher the flow rate of the purging gas and/or the longer the purging time is, the larger is the amount, in particular the mass, of the purging gas that is introduced in total into the process chamber for purging.

Before purging, the temperature and oxygen concentration within the process chamber are the temperature and oxygen concentration of a gas initially contained within the process chamber. During purging, the temperature and oxygen concentration within the process chamber are the temperature and oxygen concentration of a mixture of the gas initially contained within the process chamber and the purging gas. After purging, the temperature and oxygen concentration within the process chamber are the temperature and oxygen concentration of the purging gas and a potential remainder of the gas initially contained within the process chamber. The temperature and oxygen concentration within the process chamber are preferably measured at least during a part of step a). Additionally, the temperature and oxygen concentration within the process chamber can also be measured during at least a part of step β).

The flow rate of the purging gas and/or the purging time are preferably controlled such that the consumption of the purging gas is as low as achievable In many applications in particular the purging time is of particular importance. Thus, it is particularly preferred to reduce the purging time. The flow rate of the purging gas and/or the purging time can be controlled as described,, for example, by introducing the purging gas only if the temperature within the process chamber is higher than a predetermined threshold value. The threshold value can be predetermined, for example, depending on the elapsed time and/or the oxygen concentration within the process chamber. In particular, the predetermined value can be set to a value equal to or greater than the first temperature.

In a further preferred embodiment of the method the first temperature is determined such that after step β) an oxygen concentration within the process chamber is below a predetermined maximum oxygen concentration if a volume of the purging gas introduced into the process chamber in step β) is a factor of less than 1.5 larger than a total volume of the process chamber.

As an inert atmosphere can be characterized by a maximum oxygen concentration, this embodiment is particularly suitable for obtaining an inert atmosphere within the process chamber.

The higher the first temperature is, the less purging gas has to be introduced into the process chamber. Thus, the first temperature can be chosen such that for a given amount of purging gas available for purging, the oxygen concentration is reduced below the predetermined maximum oxygen concentration. In this embodiment, the amount of purging gas that can be used is set to be maximally 1.5 times the total volume of the process chamber. Therein, the volume is supposed to be determined at the actual temperature and the actual pressure of the purging gas. Should the temperature and/or the pressure of the purging gas vary during purging, respective mean values are supposed to be considered.

A dependence of the oxygen concentration reached after purging over a certain purging time and with a certain flow rate of the purging gas from the first temperature can be determined experimentally, in particular for different purging times and/or different flow rates of the purging gas. The obtained dependence can, for example, be stored as a look-up table in a control unit of the process chamber.

In a further preferred embodiment of the method the first temperature is determined such that after step β) an oxygen concentration within the process chamber is below a predetermined maximum oxygen concentration if a purging time, over which step β) is performed, is less than 5 minutes.

Similar to the previous embodiment, the present embodiment is particularly suitable for obtaining an inert atmosphere within the process chamber. Here, it is the purging time that is addressed. A total amount of the purging gas that is introduced into the process chamber is determined by the flow rate at which the purging gas is introduced into the process chamber and the total time of purging (purging time). In particular, the amount of the purging gas, in particular the mass or the volume of the purging gas, can be obtained as a time integral of the mass flow rate or the volume flow rate, respectively. Thus, a certain total amount of the purging gas and a certain flow rate of the purging gas correspond to a respective purging time. Thus, the purging time requirement corresponds to a certain combination of the total amount of the purging gas and the flow rate of the purging gas, which in turn correspond to a certain first temperature.

A dependence of the oxygen concentration reached after purging with a certain flow rate of the purging gas from the first temperature can be determined experimentally, in particular for different flow rates of the purging gas. The obtained dependence can, for example, be stored as a look-up table in a control unit of the process chamber.

As a further aspect a method is provided that comprises purging the process chamber according to both above described methods. This method is a combination, in which the process chamber is purged in particular by performing the steps a) and b) as well as α) and β). During purging, thus, the volumes of the purging section and the remaining section can be varied as described before, after or during increasing the temperature according to step α). In particular it is preferred that step a) is performed at first, followed by step α) and finally by steps b) and β). Steps b) and β) are preferably performed simultaneously. Thus, steps b) and β) may also be considered a single step. In step a) the temperature within the entire process chamber or merely in the purging section can be increased. Further, it is possible to perform the two different methods for purging after each other such that an oxygen concentration remaining after one of the methods has been performed can be reduced even further by performing the other method. The details and advantages disclosed for the methods for purging the process chamber can be applied to the present combined method, and vice versa.

According to a further aspect of the present invention a method is provided that comprises manufacturing a three-dimensional product within a process chamber by way of additive manufacturing after the process chamber has been purged by the described method.

The details and advantages disclosed for the two methods for purging the process chamber can be applied to the present method, and vice versa.

Additive manufacturing can be performed to manufacture three dimensional products. Thereby, the material of the product is provided as a powder within the process chamber. The powder thus can be referred to as a precursor material. By locally heating up the precursor powder, for example by a laser, the powder can be molten and thus transformed into solid material locally. If this is performed for several powder layers, the product can be obtained layer by layer.

Additive manufacturing is preferably performed in an inert atmosphere. This can prevent oxidization of the powder and/or the product. Also, residual powder and fumes can be removed from the powder layer surface by a flow of the inert gas. The inert gas can also prevent or at least reduce deposition of fumes and spatters on the powder.

As a further aspect a method is provided that comprises using a process chamber as an autoclave after the process chamber has been purged by the described method.

The details and advantages disclosed for the two methods for purging the process chamber can be applied to the present method, and vice versa.

An autoclave is a process chamber that can be sealed in a gas-tight manner and that can be used, in particular, for thermal and/or chemical treatment of a product. Such thermal treatment is preferably performed in an inert atmosphere to avoid oxidization of the treated product.

In particular in an autoclave a predetermined atmosphere comprising ammonium can be used.

As a further aspect a control unit is provided that is configured for performing any of the described methods.

The details and advantages disclosed for the described methods can be applied to the control unit, and vice versa.

The control unit is preferably connected to at least one pressure sensor, at least one temperature sensor and/or at least one sensor for measuring gas concentrations, in particular an oxygen concentration within the process chamber.

Further, the control unit is preferably connected to one or more ports for introducing a gas, in particular the purging gas, into the process chamber and/or for removing a gas from the process chamber. The at least one port can preferably be opened and closed by the control unit. Further, it is preferred that a position of a movable separation element can be controlled by the control unit.

As a further aspect a process chamber is provided that comprises a separating means for dividing the process chamber into a purging section and a remaining section.

The details and advantages disclosed for the described methods can be applied to the process chamber, and vice versa.

The process chamber is configured for performing the described method for purging the process chamber, the described method comprising manufacturing a three-dimensional product within the process chamber by way of additive manufacturing and/or the described method comprising using the process chamber as an autoclave. The heater can be, for example, an electric heater, particularly a heating coil, within the process chamber.

In a preferred embodiment the process chamber is configured for performing at least one of the described methods.

Preferably, the process chamber comprises at least a heater for increasing the temperature within the process chamber and a control unit for measuring and controlling a temperature within the process chamber and/or a flow rate of a purging gas at least during purging. The heater can be, for example, a heating coil within the process chamber. The process chamber preferably comprises at least a heater for increasing the temperature within the process chamber and a control unit for measuring and controlling a temperature within the process chamber and/or a flow rate of a purging gas at least during purging.

In a first alternative, the purging section or the remaining section of the process chamber is formed within at least one inflatable element.

The inflatable element preferably remains within the process chamber at all times. That is, at all times the process chamber is divided into the purging section and the remaining section. One of the sections is formed within the at least one inflatable element, the other section is formed outside the at least one inflatable element. The volume of the section formed within the at least one inflatable element and/or the volume of the section formed outside the at least one inflatable element can also be 100 % of the total volume of the process chamber and/or can also be zero.

In a further preferred embodiment of the process chamber the at least one inflatable element is at least one of the following:
- a bag,
- a bellows,
- a balloon.

The process chamber further comprises at least one closable connection between the purging section and the remaining section of the processing chamber.

The at least one closable connection preferably comprises at least one vale that can be controlled electronically, in particular by the control unit.

In a second alternative, the process chamber further comprises at least one movable separation element between the purging section and the remaining section of the processing chamber.

The described method has in particular two groups of embodiments. In a first group of preferred embodiments, the volume of the remaining section and/or the volume of the purging section can be increased or decreased by introducing a gas or a liquid into one of the sections and/or by removing a gas or a liquid from one of the sections. In a second group of embodiments the volume of the remaining section and/or the volume of the purging section can be increased or decreased by mechanically moving at least one movable separation element. It is possible to combine both ways to increase or decrease the volumes of the sections. In particular, an embodiment of the method is preferred, in which the volume of the remaining section and/or the volume of the purging section is increased or decreased partly by introducing a gas or a liquid into one of the sections and/or by removing a gas or a liquid from one of the sections, and partly by mechanically moving at least one movable separation element.

Thus, according to the invention, at least a part of the purging section or a part of the remaining section of the process chamber is formed within at least one inflatable element or the process chamber comprises at least one movable separation element between at least a part of the purging section and at least a part of the remaining section of the processing chamber.

As a further aspect a use of a process chamber dividable into a purging section and a remaining section for purging the process chamber with a purging gas is provided. The details and advantages disclosed for the described methods, the process chamber and the control unit can be applied to the described use, and vice versa.

In a preferred embodiment of the use a three-dimensional product is manufactured within the process chamber by way of additive manufacturing or the process chamber is used as an autoclave.

Depending on the oxygen concentration to be reached by purging, it is preferred to repeat the purging process at least once to reach the desired oxygen concentration.

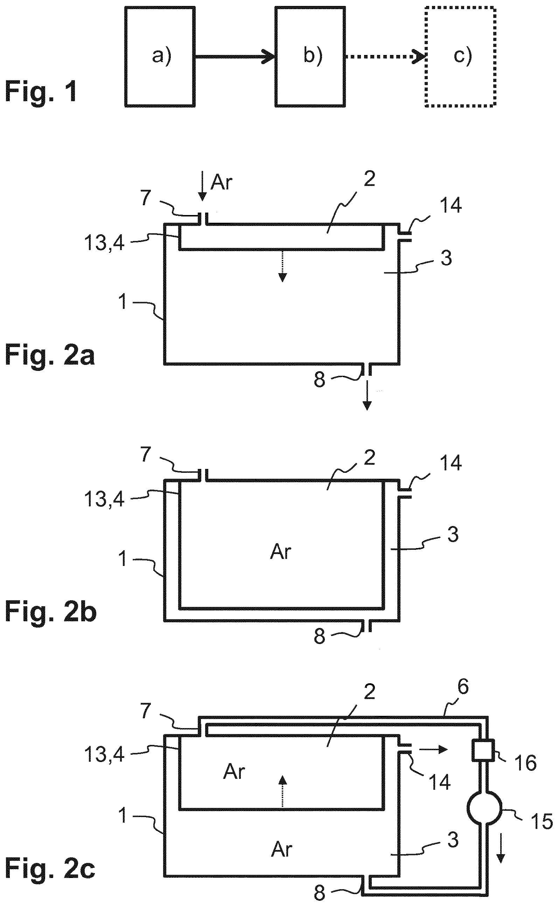

It should be noted that the individual features specified in the claims may be combined with one another in any desired technological reasonable manner and form further embodiments of the invention. The specification, in particular taken together with the figures, explains the invention further and specifies particularly preferred embodiments of the invention. Particularly preferred variants of the invention and the technical field will now be explained in more detail with reference to the enclosed figures. It should be noted that the exemplary embodiments shown in the figures are not intended to restrict the invention. The figures are schematic and may not be to scale. The figures, of which only Fig. 1, 2a to 2c, 3a to 3c, 6a to 6c, 7, 8 and 9 show embodiments within the scope of the claims, display:
- Fig. 1:: a schematic view of a method for purging a process chambers,
- Fig. 2a to 2c:: three views of stages of a first embodiment of the method of fig. 1,
- Fig. 3a to 3c:: three views of stages of a second embodiment of the method of fig. 1,
- Fig. 4a to 4c:: three views of stages of a third embodiment of the method of fig. 1,
- Fig. 5a to 5c:: three views of stages of a fourth embodiment of the method of fig. 1,
- Fig. 6a to 6c:: three views of stages of a fifth embodiment of the method of fig. 1,
- Fig. 7:: a view of one stage of a sixth embodiment of the method of fig. 1,
- Fig. 8:: a view of one stage of a seventh embodiment of the method of fig. 1,
- Fig. 9:: a view of one stage of a eighth embodiment of the method of fig. 1,
- Fig. 10:: a schematic view of a first embodiment of a process chamber;
- Fig. 11:: a schematic view of a second embodiment of a process chamber;
- Fig. 12:: a schematic view of a third embodiment of a process chamber; and
- Fig. 13:: a schematic view of a method for purging the process chamber of either of fig. 10 to 12.

Fig. 1 depicts a method for purging a process chamber 1 (as shown in fig. 2a to 9).

The method comprises the following steps:
a) providing a purging section 2 within the process chamber 1 such that a volume of the purging section 2 is smaller than a total volume of the process chamber 1, and
b) introducing a purging gas into the purging section 2 of the process chamber 1.

The method further comprises the following step, which is depicted with dotted lines in fig. 1:
c) reducing the volume of the purging section 2, thereby increasing the volume of the remaining section 3, wherein the purging gas contained within the purging section 2 is transferred to the remaining section 3.

Fig. 2a to 2c show three stages of a first embodiment of the method of fig. 1. The process chamber 1 is divided into a purging section 2 and a remaining section 3. The purging section 2 and the remaining section 3 are each a single continuous part of the process chamber 1. In the first embodiment, the purging section 2 is formed within an inflatable element 4 as a separation means 13. In the first embodiment argon is used as the purging gas. Argon has higher density than air, which is usually the gas initially contained within the process chamber 1. Therefore it is advantageous that the purging section 2 is situated mainly above the remaining section 3.

In Fig. 2a the purging section 2 as provided by step a) is significantly smaller than the remaining section 3. Prior to step b) the volume of the purging section 2 of the process chamber 1 is less than 10 % of a total volume of the process chamber 1. The purging section 2 exists permanently, that is, not only during purging of the process chamber 1. Via a first port 7 argon (Ar) as a purging gas can be introduced into the purging section 2 according to step b). Thus, the volume of the purging section 2 is increased, thereby decreasing the volume of the remaining section 3 correspondingly. The inflation of the inflatable element 4 is indicated by a dotted arrow. For the pressure within the remaining section 3 to not be increased by the reduction of the volume of the remaining section 3, gas initially contained within the remaining section 3 can exhaust from the process chamber 1 via a second port 8.

The volume of the purging section 2 is increased to almost the total volume of the process chamber 1. This is shown in fig. 2b. In the first embodiment of the method step c) is performed. That is depicted in fig. 2c, wherein the argon is transferred through a closable connection 6 between the purging section 2 and the remaining section 3. In the first embodiment the closable connection is a connection line with a pump 15 and a valve 16 between the first port 7 and the second port 8. The closable connection can be attached to the process chamber 1 at all times, that is also prior to step c). For clarity, however, the closable connection 6 is shown only in Fig. 2c and not in Fig. 2a and 2b. While the gas is transferred via the closable connection 6, gas contained within the remaining section 3 can exhaust from the process chamber 1 via a third port 14. During step c) the closable connection 6 is opened, wherein the pump is operated such that the gas is moved as indicated by an arrow. The deflation of the inflatable element 4 is indicated by a dotted arrow. During step c) it is also possible to additionally introduce nitrogen into the remaining section 3 via port 8 and/or via the closable connection 6. This, however, is not shown in Fig. 2c.

After purging the volume of the remaining section 3 is at least 90 % of the total volume of the process chamber 1. This situation is not shown explicitly. However, this situation is the same as that shown in fig. 2a, except that after purging the remaining section 3 is filled with argon instead of a gas initially contained within the process chamber 1. A remainder of the gas initially contained within the process chamber may also be contained within the remaining section 3. In the first embodiment the process for which the process chamber 1 is supposed to be used can be performed within the remaining section 3.

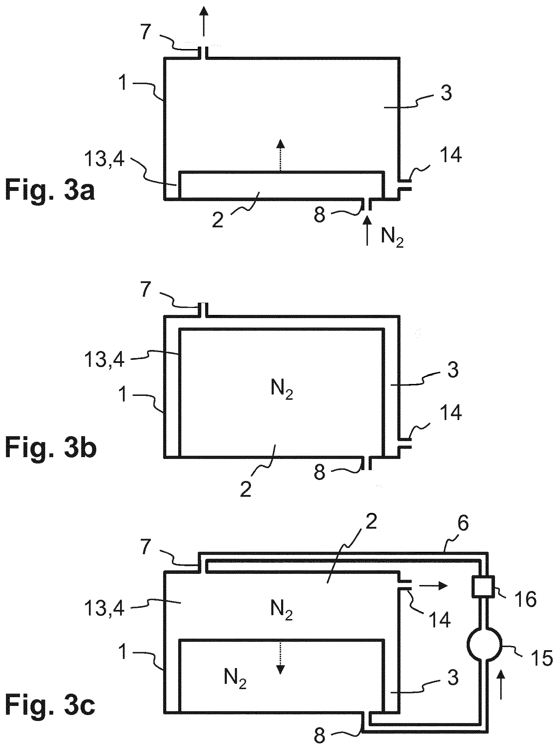

Fig. 3a to 3c show three stages of a second embodiment of the method of fig. 1. Here, only the differences compared to the first embodiment shown in fig. 2a to 2c are described. The first and second embodiments are very similar. The main difference is that the purging section 2 is located at the bottom instead of at the top of the process chamber 1. In the second embodiment nitrogen is used as the purging gas. In contrast to the argon that is used in the first embodiment, nitrogen has a density that is lower than the density of air. Thus, it is advantageous that in the second embodiment the purging section 2 is basically situated below the remaining section 3.

However, it is also possible to use a process chamber 1 as depicted in fig. 2a to 2c with nitrogen and to use a process chamber 1 as depicted in fig. 3a to 3c with argon.

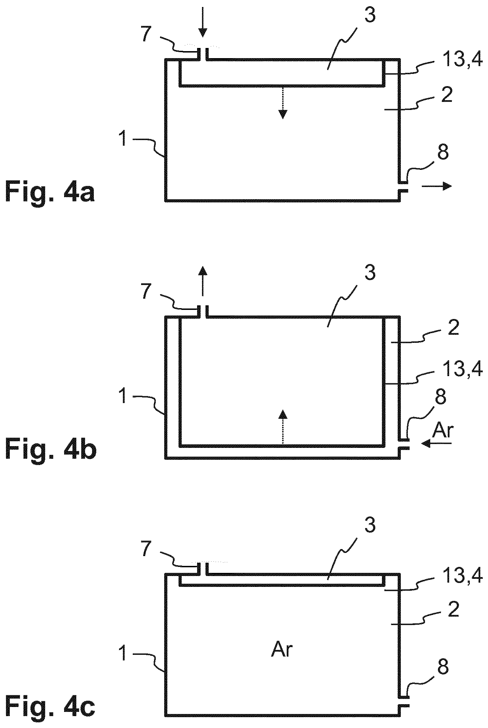

Fig. 4a to 4c show three stages of a third embodiment of the method of fig. 1. Here, only the differences compared to the first embodiment shown in fig. 2a to 2c are described. In the third embodiment the remaining section 3 is formed within an inflatable element 4.

Providing the purging section 2 within the meaning of step a) is achieved here by first increasing the volume of the remaining section 3 as indicated by the dotted arrow in fig. 3a. Therefore, any gas and/or liquid can be introduced into the remaining section 3 via the first port 7. As the second port 8 is opened, the gas initially contained within the purging section 2 can be removed from the process chamber 1 via the second port 8. Thus, the volume of the purging section 2 is reduced to such an extent that the volume of the remaining section 3 is almost equal to the total volume of the process chamber 1 as shown in fig. 4b. Subsequently, argon as the purging gas can be introduced into the purging section 2 via the second port 8, thus increasing the volume of the purging section 2 as indicated by the dotted arrow. Gas and/or liquid contained within the remaining section 3 can thereby be removed from the process chamber 1 via the first port 7. Finally, the volume of the purging section 2 is at least 90 % of the total volume of the process chamber 1 after purging. In the second embodiment, the process for which the process chamber 1 is supposed to be used can be performed within the remaining section 3.

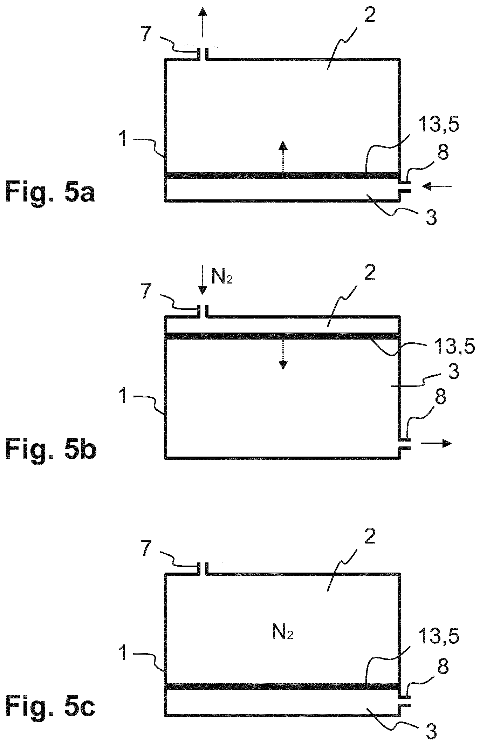

Fig. 5a to 5c show three stages of a fourth embodiment of the method of fig. 1. Here, only the differences compared to the first embodiment shown in fig. 2a to 2c are described. In the fourth embodiment, a movable separation element 5 as a separation means 13 is provided between the purging section 2 and the remaining section 3. As here a movable separation element 5 is used, the disadvantages resulting from the density of the purging gas can be less pronounced than with the inflatable element 4 of the previous embodiments.

As can be seen in fig. 5a, the purging section 2 can be provided within the meaning of step a) by moving the movable separation element 5 upward as indicated by a dotted arrow. Thereby, the volume of the remaining section 3 is increased correspondingly. The first port 7 and the second port 8 are opened such that gas initially contained within the purging section 2 can be removed from the process chamber 1 and such that any other gas can be introduced into the remaining section 3.

After the purging section 2 is as small as shown in fig. 5b, nitrogen as the purging gas can be introduced into the purging section 2 via the first port 7. Thereby, the movable separation element 5 is moved downward as indicated by a dotted arrow. Thus, the volume of the purging section 2 is increased and the volume of the remaining section 3 is decreased correspondingly. The second port 8 is opened such that gas from the remaining section 3 can escape the process chamber 1.

Finally, the volume of the purging section 2 is 90 % of the total volume of the process chamber 1 after purging. In the third embodiment the process for which the process chamber 1 is supposed to be used can be performed within the purging section 2. In particular, the movable separation element 5 can be used as a substrate for such a process.

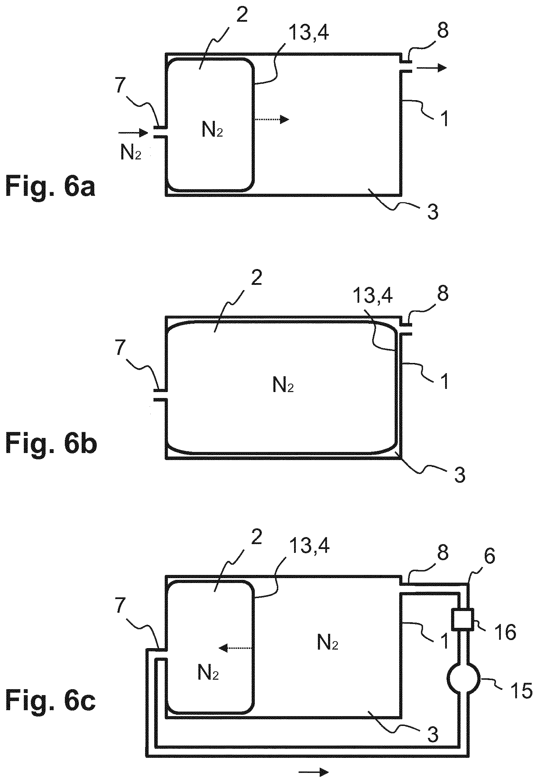

Fig. 6a to 6c show three stages of a fifth embodiment of the method of fig. 1. Here, only the differences compared to the first embodiment shown in fig. 2a to 2c are described. In the fifth embodiment the purging section 2 is formed within an inflatable element 4 as a separation means 13. Here, the inflatable element 4 is arranged such that it can expand from left to right. Thus, the fifth embodiment is basically independent from the density of the purging gas. Here, the fist port 7 and the second port 8 are arranged laterally at the process chamber 1.

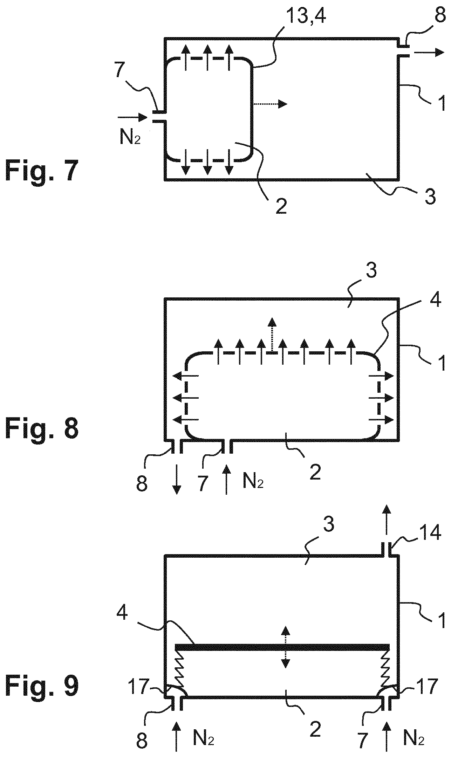

Fig. 7 shows an exemplary view of one stage of a sixth embodiment of the method of fig. 1. Here the purging section 2 is formed within an inflatable element 4 as a separation means 13. The inflatable element 4 in this embodiment is a balloon that is made partly of a gas-permeable material. Thus, as indicated by solid arrows, gas can penetrate through the balloon. In the exemplarily shown stage of the method gas thus penetrates form the purging section 2 into the remaining section 3 while the volume of the purging section 2 is increased by introducing the purging gas, here nitrogen, into the purging section 2.

Fig. 8 shows an exemplary view of one stage of a seventh embodiment of the method of fig. 1. The seventh embodiment is similar to the sixth embodiment shown in fig. 7. Here, the inflatable element 4 is a balloon that is made entirely of a gas-permeable material. Also, the inflatable element 4 is arranged at the bottom of the process chamber 1 here.

Fig. 9 shows an exemplary view of one stage of a eighth embodiment of the method of fig. 1. Therein, the separating means 13 is an inflatable element 4. The inflatable element 4 is realized here as bellows. Nitrogen as the purging gas can be introduced into the process chamber 1 via the first port 7 and the second port 8. Mounts 17 for the bellows are provided. The mounts 17 are made of a gas-permeable material such as a sintered metal. Thus, the nitrogen that is introduced into process chamber 1 penetrates through the mounts 17 into both the purging section 2 and the remaining section 3. The bellows can be moved as indicated by the dotted double arrow, thus increasing and reducing the volumes of the purging section 2 and the remaining section 3.

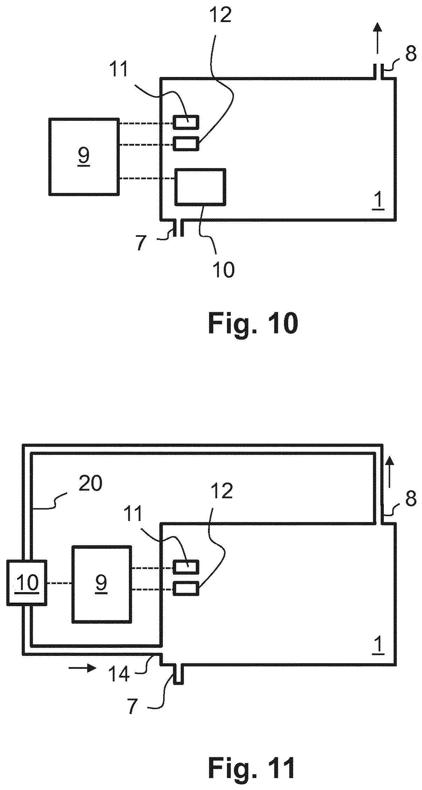

Fig. 10 shows a process chamber 1 with a control unit 9 that is connected to a heater 10, a temperature sensor 11 and an oxygen sensor 12. The process chamber 1 comprises a first port 7 and a second port 8. During heating the process chamber 1 by the heater 10 gas contained within the process chamber 1 can exhaust via the second port 8 while the first port 7 is closed.

Fig. 11 shows a process chamber 1. Here, in contrast to fig. 1, the heater 10 is provided within a connection line 20 between a third port 14 and the first port 7. By circulating the gas through the connection line 6 and the process chamber 1 as indicated by an arrow, the gas contained within the process chamber 1 can be heated by the heater 10. Therefore, the heater 10 is preferably embodied as a circulation heater.

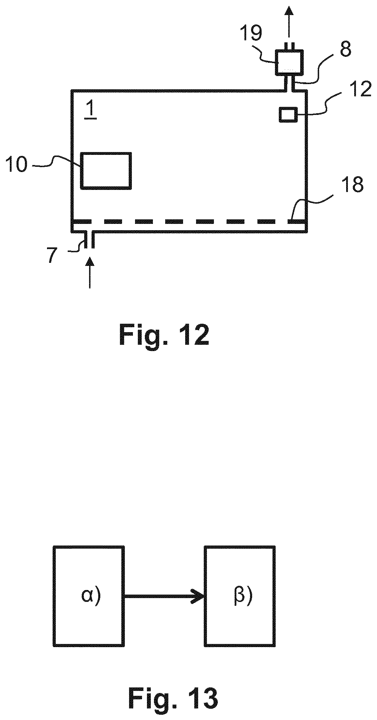

Fig. 12 shows a process chamber 1. Here, only the oxygen sensor 12 and the heater 10 are shown. Gas can be introduced into the process chamber 1 via the first port 7, whereas exhaust of gas from the process chamber 1 via the second port 8 can be controlled by a valve 19. Also, a distributing element 18 made of a sinter material and/or a tissue is provided within the process chamber 1. The gas introduced into the process chamber 1 via the first port 7 can penetrate through the distributing element 18 allowing an improved distribution of the gas in the process chamber 1. The distributing element 18 is shaped such that it improves the distribution of the gas entering the process chamber 1. In particular, the distributing element 18 is adapted based on the geometry, size of and/or flow velocity distribution of gas within the process chamber 1 ensuring a distribution of the gas being adapted to the process chamber 1.

The process chamber 1 of either of fig. 10 to 12 can be purged according to a method depicted in fig. 13, which comprises the following steps:
α) increasing a temperature of a gas initially contained in the process chamber 1 at least to a first temperature,
β) introducing a purging gas, which is at a second temperature, into the process chamber 1, wherein the first temperature is higher than the second temperature, which is below 0 °C.

The purging gas is provided by evaporating liquid nitrogen prior to step β) and using the evaporated nitrogen as the purging gas in step β). Nitrogen is an inert gas.

Step β) is performed at least to such an extent that an oxygen concentration within the process chamber 1 is below 1000 ppm [parts per million] after step β).

At least one of the following parameters
- a flow rate of the purging gas in step β) and
- a purging time, over which step β) is performed,
is controlled depending on at least one of the following parameters:
- a temperature measured by the temperature sensor 11 within the process chamber 1 and
- an oxygen concentration measured by the oxygen sensor 12 (shown only in fig. 10 and 11) within the process chamber 1.

The first temperature is determined such that after step β) an oxygen concentration within the process chamber 1 is below a predetermined maximum oxygen concentration if a volume of the purging gas introduced into the process chamber 1 in step β) is a factor of less than 1.5 larger than a total volume of the process chamber 1 and/or if a purging time, over which step β) is performed, is less than 5 minutes.

After the process chamber 1 has been purged according to the method depicted in fig. 6, the process chamber 1 can be used in particular for manufacturing a three-dimensional product by way of additive manufacturing or as an autoclave.

After the process chamber 1 has been purged the process chamber 1 can be used in particular for manufacturing a three-dimensional product within the process chamber 1 by way of additive manufacturing or as an autoclave.

With the provided method, a process chamber 1 can be purged with a purging gas such as nitrogen and/or argon at a particularly low consumption of the purging gas and/or with a particularly short purging time. This can be achieved by introducing the purging gas into a small purging section 2 of the process chamber 1, whereby the volume of the purging section 2 is increased.

### List of reference numerals

- 1: process chamber
- 2: purging section
- 3: remaining section
- 4: inflatable element
- 5: movable separation element
- 6: closable connection
- 7: first port
- 8: second port
- 9: control unit
- 10: heater
- 11: temperature sensor
- 12: oxygen sensor
- 13: separation means
- 14: third port
- 15: pump
- 16: valve
- 17: mount
- 18: distributing element
- 19: valve
- 20: connection line

## Claims

1. Method for purging a process chamber (1), comprising at least the following steps:
a) providing a purging section (2) within the process chamber (1) such that a volume of the purging section (2) is smaller than a total volume of the process chamber (1), and
b) introducing a purging gas into the purging section (2) of the process chamber (1),
wherein the process chamber (1) is divided into the purging section (2) and a remaining section (3), wherein
the purging section (2) or the remaining section (3) of the process chamber (1) is formed within at least one inflatable element (4)
or
the process chamber (1) comprises at least one movable separation element (5) between the purging section (2) and the remaining section (3) of the processing chamber (1),
wherein in step b) the volume of the purging section (2) is increased by introducing of the purging gas, thereby reducing the volume of the remaining section (3) and removing a gas contained in the remaining section (3) from the process chamber (1), and wherein the method further comprises the following step, which is performed after step b):
c) reducing the volume of the purging section (2), thereby increasing the volume of the remaining section (3),
**characterized in that**
in step c) the purging gas contained within the purging section (2) is transferred to the remaining section (3).

2. Method according to claim 1, wherein prior to step b) the volume of the purging section (2) of the process chamber (1) is less than 10 % of a total volume of the process chamber (1).

3. Method according to claim 1, wherein after purging the volume of the remaining section (3) is at least 90 % of the total volume of the process chamber (1).

4. Method according to claim 1, wherein in step a) the volume of the remaining section (3) is increased, thereby reducing the volume of the purging section (2) and removing a gas contained within the purging section (2) from the process chamber (1).

5. Method according to claim 4, wherein at least one movable separation element (5) between the purging section (2) and the remaining section (3) is moved to increase or decrease the volume of the purging section (2) of the process chamber (1), thereby decreasing or increasing the volume of the remaining section (3) of the process chamber (1), respectively.

6. Method according to claim 4 or 5, wherein the volume of the purging section (2) is at least 70 % of the total volume of the process chamber (1) after purging.

7. Method comprising manufacturing a three-dimensional product within a process chamber (1) by way of additive manufacturing after the process chamber (1) has been purged by a method according to any of the preceding claims.

8. Method comprising using a process chamber (1) as an autoclave after the process chamber (1) has been purged by a method according to any of the claims 1 to 6.

9. Process chamber (1) comprising a separating means (13) for dividing the process chamber (1) into a purging section (2) and a remaining section (3), wherein the volume of the purging section (2) can be increased by introducing of a purging gas, thereby reducing the volume of the remaining section (3) and removing a gas contained in the remaining section (3) from the process chamber (1), wherein
the purging section (2) or the remaining section (3) of the process chamber (1) is formed within at least one inflatable element (4)
or
the process chamber (1) comprises at least one movable separation element (5) between the purging section (2) and the remaining section (3) of the processing chamber (1),
and wherein the process chamber (1) further comprises at least one closable connection (6) between the purging section (2) and the remaining section (3) of the processing chamber (1).

10. Process chamber according to claim 9, wherein the at least one inflatable element (4) is at least one of the following:
- a bag,
- a bellows,
- a balloon.

11. Use of a process chamber (1) according to claim 9 or 10 dividable into a purging section (2) and a remaining section (3) for purging the process chamber (1) with a purging gas by a method according to one of claims 1 to 6.

12. Use according to claim 11, wherein a three-dimensional product is manufactured within the process chamber (1) by way of additive manufacturing or wherein the process chamber (1) is used as an autoclave.

## Patentansprüche

1. Verfahren zum Spülen einer Prozesskammer (1), das mindestens die folgenden Schritte umfasst:
a) Bereitstellen eines Spülabschnitts (2) in der Prozesskammer (1), derart, dass ein Volumen des Spülabschnitts (2) kleiner als ein Gesamtvolumen der Prozesskammer (1) ist, und
b) Einbringen eines Spülgases in den Spülabschnitt (2) der Prozesskammer (1),
wobei die Prozesskammer (1) in den Spülabschnitt (2) und einen übrigen Abschnitt (3) unterteilt ist, wobei
der Spülabschnitt (2) oder der übrige Abschnitt (3) der Prozesskammer (1) innerhalb mindestens eines aufblasbaren Elements (4) gebildet werden
oder
die Prozesskammer (1) mindestens ein bewegliches Trennelement (5) zwischen dem Spülabschnitt (2) und dem übrigen Abschnitt (3) der Prozesskammer (1) umfasst,
wobei in Schritt b) das Volumen des Spülabschnitts (2) durch das Einbringen des Spülgases vergrößert wird, wodurch das Volumen des übrigen Abschnitts (3) verringert wird und ein Gas, das im übrigen Abschnitt (3) enthalten ist, aus der Prozesskammer (1) entfernt wird, und wobei das Verfahren ferner den folgenden Schritt umfasst, der nach Schritt b) durchgeführt wird:
c) Verringern des Volumens des Spülabschnitts (2), wodurch das Volumen des übrigen Abschnitts (3) vergrößert wird,
**dadurch gekennzeichnet, dass** in Schritt c) das Spülgas, das im Spülabschnitt (2) enthalten ist, zum übrigen Abschnitt (3) übertragen wird.

2. Verfahren nach Anspruch 1, wobei vor Schritt b) das Volumen des Spülabschnitts (2) der Prozesskammer (1) kleiner als 10 % eines Gesamtvolumens der Prozesskammer (1) ist.

3. Verfahren nach Anspruch 1, wobei nach dem Spülen das Volumen des übrigen Abschnitts (3) mindestens 90 % des Gesamtvolumens der Prozesskammer (1) ist.

4. Verfahren nach Anspruch 1, wobei in Schritt a) das Volumen des übrigen Abschnitts (3) vergrößert wird, wodurch das Volumen des Spülabschnitts (2) verringert wird und ein Gas, das im Spülabschnitt (2) enthalten ist, aus der Prozesskammer (1) entfernt wird.

5. Verfahren nach Anspruch 4, wobei mindestens ein bewegliches Trennelement (5) zwischen dem Spülabschnitt (2) und dem übrigen Abschnitt (3) bewegt wird, um das Volumen des Spülabschnitts (2) der Prozesskammer (1) zu vergrößern oder zu verkleinern, wodurch das Volumen des übrigen Abschnitts (3) der Prozesskammer (1) verkleinert bzw. vergrößert wird.

6. Verfahren nach Anspruch 4 oder 5, wobei das Volumen des Spülabschnitts (2) nach dem Spülen mindestens 70 % des Gesamtvolumens der Prozesskammer (1) ist.

7. Verfahren, das die Herstellung eines dreidimensionalen Erzeugnisses in einer Prozesskammer (1) mittels additiver Herstellung, nachdem die Prozesskammer (1) durch ein Verfahren nach einem der vorhergehenden Ansprüche gespült worden ist, umfasst.

8. Verfahren, das das Verwenden einer Prozesskammer (1) als einen Autoklaven, nachdem die Prozesskammer (1) durch ein Verfahren nach einem der Ansprüche 1 bis 6 gespült worden ist, umfasst.

9. Prozesskammer (1), die ein Trennmittel (13) zum Unterteilen der Prozesskammer (1) in einen Spülabschnitt (2) und einen übrigen Abschnitt (3) umfasst, wobei das Volumen des Spülabschnitts (2) durch Einbringen eines Spülgases vergrößert werden kann, wodurch das Volumen des übrigen Abschnitts (3) verringert wird und ein Gas, das im übrigen Abschnitt (3) enthalten ist, aus der Prozesskammer (1) entfernt wird, wobei
der Spülabschnitt (2) oder der übrige Abschnitt (3) der Prozesskammer (1) innerhalb mindestens eines aufblasbaren Elements (4) gebildet werden
oder
die Prozesskammer (1) mindestens ein bewegliches Trennelement (5) zwischen dem Spülabschnitt (2) und dem übrigen Abschnitt (3) der Prozesskammer (1) umfasst,
und wobei die Prozesskammer (1) ferner mindestens eine verschließbare Verbindung (6) zwischen dem Spülabschnitt (2) und dem übrigen Abschnitt (3) der Prozesskammer (1) umfasst.

10. Prozesskammer nach Anspruch 9, wobei das mindestens eine aufblasbare Element (4) mindestens eines des Folgendes ist:
- ein Beutel,
- ein Balg,
- ein Ballon.

11. Verwendung einer Prozesskammer (1) nach Anspruch 9 oder 10, die zum Spülen der Prozesskammer (1) mit einem Spülgas durch ein Verfahren nach einem der Ansprüche 1 bis 6 in einen Spülabschnitt (2) und einen übrigen Abschnitt (3) unterteilbar ist.

12. Verwendung nach Anspruch 11, wobei ein dreidimensionales Erzeugnis mittels additiver Herstellung in der Prozesskammer (1) hergestellt wird oder wobei die Prozesskammer (1) als ein Autoklav verwendet wird.

## Revendications

1. Procédé pour purger une chambre de traitement (1), comprenant au moins les étapes suivantes :
a) la fourniture d'une section de purgeage (2) à l'intérieur de la chambre de traitement (1) de manière telle qu'un volume de la section de purgeage (2) est plus petit qu'un volume total de la chambre de traitement (1), et
b) l'introduction d'un gaz de purgeage dans la section de purgeage (2) de la chambre de traitement (1),
dans lequel la chambre de traitement (1) est divisée en la section de purgeage (2) et une section restante (3), dans lequel
la section de purgeage (2) ou la section restante (3) de la chambre de traitement (1) est formée à l'intérieur d'au moins un élément gonflable (4)
ou
la chambre de traitement (1) comprend au moins un élément de séparation mobile (5) entre la section de purgeage (2) et la section restante (3) de la chambre de traitement (1),
dans lequel, dans l'étape b) le volume de la section de purgeage (2) est augmenté par l'introduction du gaz de purgeage, ainsi réduisant le volume de la section restante (3) et éliminant un gaz, contenu dans la section restante (3), de la chambre de traitement (1), et dans lequel le procédé comprend en outre l'étape suivante, qui est réalisée après l'étape b) :
c) la réduction du volume de la section de purgeage (2), ainsi augmentant le volume de la section restante (3),
**caractérisé en ce que**, dans l'étape c), le gaz de purgeage contenu à l'intérieur de la section de purgeage (2) est transféré à la section restante (3).

2. Procédé selon la revendication 1, dans lequel, avant l'étape b), le volume de la section de purgeage (2) de la chambre de traitement (1) est inférieur à 10 % d'un volume total de la chambre de traitement (1).

3. Procédé selon la revendication 1, dans lequel, après le purgeage, le volume de la section restante (3) est au moins 90 % du volume total de la chambre de traitement (1).

4. Procédé selon la revendication 1, dans lequel, dans l'étape a), le volume de la section restante (3) est augmenté, ainsi réduisant le volume de la section de purgeage (2) et éliminant un gaz, contenu à l'intérieur de la section de purgeage (2), de la chambre de traitement (1).

5. Procédé selon la revendication 4, dans lequel au moins un élément de séparation mobile (5) entre la section de purgeage (2) et la section restante (3) est mû pour augmenter ou réduire le volume de la section de purgeage (2) de la chambre de traitement (1), ainsi réduisant ou augmentant le volume de la section restante (3) de la chambre de traitement (1), respectivement.

6. Procédé selon la revendication 4 ou 5, dans lequel le volume de la section de purgeage (2) est au moins 70 % du volume total de la chambre de traitement (1) après le purgeage.

7. Procédé, comprenant la fabrication d'un produit tridimensionnel à l'intérieur d'une chambre de traitement (1) par le biais de fabrication additive après que la chambre de traitement (1) a été purgée par l'intermédiaire d'un procédé selon de quelconques des revendications précédentes.

8. Procédé, comprenant l'utilisation d'une chambre de traitement (1) en tant qu'autoclave après que la chambre de traitement (1) a été purgée par l'intermédiaire d'un procédé selon de quelconque des revendications 1 à 6.

9. Chambre de traitement (1), comprenant un moyen de séparation (13) pour diviser la chambre de traitement (1) en une section de purgeage (2) et une section restante (3), le volume de la section de purgeage (2) pouvant être augmenté par l'intermédiaire de l'introduction d'un gaz de purgeage, ainsi réduisant le volume de la section restante (3) et éliminant un gaz, contenu dans la section restante (3), de la chambre de traitement (1), dans laquelle
la section de purgeage (2) ou la section restante (3) de la chambre de traitement (1) est formée à l'intérieur d'au moins un élément gonflable (4)
ou
la chambre de traitement (1) comprend au moins un élément de séparation mobile (5) entre la section de purgeage (2) et la section restante (3) de la chambre de traitement (1),
et dans laquelle la chambre de traitement (1) comprend en outre au moins un raccord fermable (6) entre la section de purgeage (2) et la section restante (3) de la chambre de traitement (1).

10. Chambre de traitement selon la revendication 9, dans laquelle l'au moins un élément gonflable (4) est au moins un élément parmi ce qui suit :
- un sac,
- un soufflet,
- un ballon.

11. Utilisation d'une chambre de traitement (1) selon la revendication 9 ou 10 pouvant être divisée en une section de purgeage (2) et une section restante (3) pour purger la chambre de traitement (1) avec un gaz de purgeage par l'intermédiaire d'un procédé selon l'une des revendications 1 à 6.

12. Utilisation selon la revendication 11, dans laquelle un produit tridimensionnel est fabriqué à l'intérieur de la chambre de traitement (1) par le biais de fabrication additive ou dans laquelle la chambre de traitement (1) est utilisée en tant qu'autoclave.
